# FASCICULE DE BREVET EUROPEEN

(11) **EP 4 527 157 B1**
(45) Date de publication et mention de la délivrance du brevet: **03.06.2026**
(21) Numéro de dépôt: 23725386.9
(22) Date de dépôt: 19.04.2023
(51) Int. Cl.: H05K 7/14

(54) **GUIDE DE CONNECTEURS POUR ONDULEUR COMPORTANT UN LOGEMENT DE CAPTEUR DE TEMPÉRATURE**
VERBINDERFÜHRUNG FÜR WECHSELRICHTER MIT TEMPERATURSENSORGEHÄUSE
CONNECTOR GUIDE FOR INVERTER HAVING TEMPERATURE SENSOR HOUSING

(30) Priorité: 19.05.2022 FR 2204797
(43) Date de publication de la demande: 26.03.2025
(73) Titulaire: Nidec PSA Emotors, 78955 Carrières sous Poissy (FR)
(72) Inventeur: DELAIRE, Quentin, 92310 SEVRES (FR); MUSSEAU, Nicolas, 03410 PREMILHAT (FR); DOUBLET, Paul, 78500 SARTROUVILLE (FR)
(74) Mandataire: Feliers, Antoine Ludovic
(86) Numéro de dépôt international: PCT/FR2023/050565
(87) Numéro de publication internationale: WO 2023/222965

(56) Documents cités:
- EP-A1- 3 177 122
- EP-A1- 3 582 287
- EP-B1- 3 140 901
- EP-B1- 3 177 123
- FR-A1- 3 069 116
- US-B2- 10 778 117
- US-B2- 10 917 992

## Description

La présente invention revendique la priorité de la demande française 2204797 déposée le 19 mai 2022.

La présente invention concerne le domaine des assemblages des onduleurs électriques. Elle concerne notamment les onduleurs adaptés à piloter le fonctionnement d'une machine électrique de traction d'un véhicule électrique ou hybride, par exemple un véhicule automobile.

Un onduleur est, dans le domaine de l'électronique de puissance, un convertisseur de tension permettant de générer des tensions et des courants alternatifs à partir d'une source d'énergie électrique de tension ou de fréquence différente. Un onduleur permet notamment de générer les tensions alternatives adaptées au fonctionnement d'un moteur électrique, synchrone ou asynchrone, à partir d'une source de tension continue, telle qu'une batterie électrique.

Un onduleur polyphasé, par exemple triphasé, permet de hacher une tension continue en une tension sinusoïdale polyphasée (par exemple triphasée) équilibrée.

Les onduleurs comportent pour ce faire des modules de puissance comportant des interrupteurs électroniques, par exemple des IGBT (IGBT signifiant transistor bipolaire à grille isolée, de l'anglais « Insulated Gate Bipolar Transistor »), dont les ouvertures et les fermetures sont commandées de manière appropriée.

Un tel onduleur comporte ainsi un assemblage de plusieurs composants : cartes électroniques (carte de contrôle et carte de puissance ou « carte driver », éventuellement réunies en une seule carte), un certain nombre de modules de puissance, des liaisons électriques sous la forme de barres d'interconnexion (généralement désignées par le terme anglophone « busbars ») et des capteurs.

La ou les cartes électroniques sont formées sur des circuits imprimés, couramment appelés « PCB » (de l'anglais « Printed Circuit Board »).

Les composants de l'onduleur sont généralement placés dans un boîtier de protection également appelé carter.

Les différents composants mentionnés ci-dessus se trouvent ainsi en interface mécanique et/ou électronique les uns vis-à-vis des autres selon une configuration relativement complexe.

Le montage d'un onduleur se révèle donc complexe, et nécessite d'employer des mesures afin d'assurer le bon positionnement et la bonne orientation des composants les uns par rapport aux autres.

Notamment, les modules de puissance comportent des connecteurs mâles de commande sous la forme de broches de commandes. Les broches sont généralement appelées « pins » selon la terminologie anglophone. Les connecteurs femelles correspondants, destinés à recevoir ces broches de commande des modules de puissance peuvent être des trous de réception formés dans la carte électronique (carte de contrôle ou carte électronique unique) et permettant le soudage des broches une fois celles-ci correctement introduites au travers de la carte électronique.

Un positionnement relatif très précis et simultané doit être réalisé entre toutes les broches de commande des modules de puissance et les connecteurs femelles, à savoir les trous de réception, de la carte électronique.

Sachant qu'un module de puissance comporte plusieurs broches de commande (typiquement cinq broches, voire plus) et que les modules de puissance sont montés indépendamment dans le carter de l'onduleur, ce positionnement précis est complexe à obtenir.

Pour obtenir ce positionnement, il est connu de coiffer les connecteurs des modules de puissance avec un guide de connecteurs ou « guide pins ». Un guide de connecteurs est une pièce, par exemple en plastique, qui présente des passages calibrés dans lesquels sont introduits les connecteurs mâles des modules de puissance afin de les maintenir selon la position et l'orientation souhaitées afin de pouvoir simultanément les mettre parfaitement en regard des connecteurs femelles de la carte électronique dans laquelle ils doivent être introduits.

Par exemple, le document FR3044861 divulgue un système de type alterno-démarreur comportant des modules de puissance et un support de carte électronique formant un guide de connecteurs.

De même, le document EP 3 177 122 A1 décrit un exemple de support de carte électronique qui comporte des moyens pour le guidage d'éléments de connexion électrique de modules électroniques de puissance vers la carte.

Les documents US10778117B2, EP3582287A1 et US10917992B2 décrivent également des plaques et/ou des supports servant de guides-connecteurs.

Pour des questions de pilotage, de fiabilité, et de sécurité de l'onduleur, il est important de connaître la température des modules de puissance (ou d'avoir une information représentative de cette température). A cette fin, les modules de puissance peuvent comporter un capteur de température intégré. Alternativement, des capteurs de température externes aux modules de puissance et adaptés à fournir une mesure représentative de la température des modules de puissance peuvent être prévus. Par exemple, la température peut être avantageusement mesurée au contact d'une plaque de refroidissement des modules de puissance, par un capteur de température porté par la carte de contrôle. Le capteur de température peut ainsi comporter une thermistance fixée sur un circuit imprimé qui est rigidement lié à la carte électronique de contrôle (ou le cas échéant la carte électronique principale unique) de l'onduleur. Néanmoins, le montage d'un capteur de température qui n'est pas intégré aux modules de puissance est complexe, dans l'environnement d'un onduleur pour plusieurs raisons. Tout d'abord, du fait de l'empilement des différents éléments qui constituent l'onduleur, l'accès aux zones permettant une mesure de température (typiquement, à la plaque de refroidissement des modules de puissance) est complexe. En outre, le capteur étant généralement fixé à la carte de contrôle de l'onduleur, le respect d'une chaîne de cotes permettant de garantir que le capteur est au contact de l'élément dont la température est mesurée (par exemple la plaque de refroidissement des modules de puissance) est particulièrement complexe à garantir.

La présente invention vise ainsi à proposer un dispositif résolvant tout ou partie des problèmes évoqués ci-dessus.

L'invention porte ainsi sur un guide de connecteurs pour onduleur comportant au moins deux modules de puissance, à savoir au moins un premier module de puissance et un deuxième module de puissance, le guide de connecteurs comportant un corps rigide sensiblement plan dans lequel sont ménagés des orifices pour le passage de broches de commande des modules de puissance, lesdits orifices étant calibrés et positionnés de sorte à conformer la position et l'orientation desdites broches de commande. Le corps du guide de connecteurs comporte une portion dite intermédiaire qui est destinée à être positionnée entre le premier module de puissance et le deuxième module de puissance, ladite portion intermédiaire comportant un logement adapté à recevoir un capteur de température.

Les modules de puissance de l'onduleur peuvent être placés côte à côte dans un même plan. Ils peuvent notamment présenter une surface plane alignée dans un même plan.

Le guide de connecteurs permet ainsi de garantir la position et l'orientation des broches de commande des modules de puissance lors de l'assemblage d'un onduleur, et de mettre en position un (ou plusieurs) capteur de température dans l'onduleur. Il garantit également, le cas échéant, la position et l'orientation des connecteurs du (ou des) capteur de température. Ces fonctions sont réalisées à l'aide d'une seule pièce, ce qui simplifie l'assemblage. En particulier, il n'est pas nécessaire d'utiliser un capteur de température intégré dans les modules de puissance, et, en profitant de l'espace entre deux modules de puissance pour intégrer le capteur de température, la chaîne de cote pour l'assemblage du capteur de température est très simple. Le capteur de température peut donc être installé de manière fiable.

Les orifices pour le passage des broches peuvent comporter une partie supérieure cylindrique droite et une partie inférieure évasée. La partie inférieure évasée de tout ou partie des orifices peut par exemple être conique. La partie inférieure évasée de deux orifices adjacents peut comporter une paroi médiane droite.

Ces configurations d'orifice de passage des broches de connexion permettent une correction relativement importante en cas d'imprécision dans leurs positions relatives et favorise leur guidage lors de la mise en place du guide de connecteurs sur les modules de puissance. En particulier, la paroi médiane droite permet de séparer efficacement les broches et évite que deux broches ne s'insèrent dans le même orifice.

Le logement adapté à recevoir un capteur de température est avantageusement ouvert sur une face inférieure du corps du guide de connecteurs de sorte à pouvoir insérer le capteur de température dans le logement par ladite face inférieure et le mettre en butée sur une butée supérieure dudit logement. Alternativement, le logement adapté à recevoir un capteur de température est ouvert sur une face supérieure du corps du guide de connecteurs de sorte à pouvoir insérer le capteur de température dans le logement par ladite face supérieure, le logement comportant en outre une butée permettant la mise en appui du capteur de température, ledit logement comportant en outre une ouverture de fond permettant un dépassement du capteur de température, le logement étant en outre doté d'un dispositif de retenue du capteur de température.

Le guide de connecteurs proposé dans l'invention peut donc être adapté à différents types de capteurs de température.

Le corps du guide de connecteurs peut comporter une première portion de recouvrement destinée à recouvrir au moins partiellement le premier module de puissance, et le corps du guide de connecteurs comporte une deuxième portion de recouvrement destinée à recouvrir au moins partiellement le deuxième module de puissance.

La portion intermédiaire est alors située entre les deux portions de recouvrement, qu'elle relie. Le recouvrement, au moins partiel, des modules de puissance permet de rigidifier le guide de connecteurs et garantit la cohésion générale de l'empilement des différents éléments de l'onduleur.

Le guide de connecteurs peut comporter trois portions de recouvrement, pour le recouvrement au moins partiel de trois modules de puissance.

L'onduleur qui met en oeuvre un tel guide de connecteurs comporte ainsi trois modules de puissance. Il s'agit de l'architecture classique d'un onduleur permettant l'obtention d'un courant sinusoïdal triphasé, permettant par exemple l'alimentation d'une machine électrique de traction d'un véhicule automobile.

Le guide de connecteurs peut comporter au moins un muret orthogonal à un plan général d'extension du corps du guide de connecteurs. Un tel muret garantit l'isolation électrique des éléments qu'il sépare, et évite en particulier la formation d'arcs électriques.

L'invention porte également sur un système comportant :
- une pluralité de modules de puissance ; chaque module de puissance comportant des broches de commande,
- un guide de connecteurs tel que décrit ci-dessus, chaque broche de commande des modules de puissance traversant un orifice du guide de connecteurs,
- un capteur de température installé dans le logement, et
- une plaque de refroidissement au contact des modules de puissance,
le capteur de température étant au contact de la plaque de refroidissement.

Dans un tel système, le guide de connecteurs comportant au moins un muret orthogonal à un plan plan général d'extension du corps du guide de connecteurs, et chaque module de puissance comportant des bornes qui s'étendent sensiblement parallèlement au plan général d'extension du corps du guide de connecteurs, l'au moins un muret du guide de connecteurs peut être interposé entres deux bornes adjacentes d'un module de puissance.

Cela permet d'éviter tout risque d'arc électrique entre les bornes, en particulier entre la borne positive en courant continu et la borne négative en courant continu des modules de puissance, et/ou cela permet de rapprocher spatialement ces bornes.

L'invention porte enfin sur un onduleur comportant un système tel que précédemment décrit, comportant en outre une carte électronique comportant des connecteurs femelles auxquels sont reliées les broches des modules de puissance.

D'autres particularités et avantages de l'invention apparaîtront encore dans la description ci-après.

Aux dessins annexés, donnés à titre d'exemples non limitatifs :
- la figure 1 représente, selon une vue schématique en trois dimensions, un guide de connecteurs conforme à un mode de réalisation de l'invention ;
- la figure 2 représente, selon une autre vue schématique en trois dimensions, le guide de connecteurs de la figure 1 ;
- la figure 3 présente, selon une vue schématique en trois dimensions, un système comportant le guide de connecteurs de la figure 1 ;
- la figure 4 présente, selon une autre vue schématique en trois dimensions, le système de la figure 3 ;
- la figue 5 illustre, selon une vue schématique en coupe, un aspect de certains modes de réalisation de la présente invention,
- la figure 6 illustre, selon une vue schématique partielle en trois dimensions, un autre aspect de certains modes de réalisation de la présente invention ;
- la figure 7 représente, selon une vue schématique partielle en trois dimensions, le montage d'un capteur de température sur un guide de connecteurs conforme à un mode de réalisation de l'invention ;
- la figure 8 représente, selon une vue partielle en coupe, le capteur de température de la figure 7 installé dans le guide de connecteurs ;
- la figure 9 représente, selon une vue schématique partielle en trois dimensions, le montage d'un autre capteur de température sur un guide de connecteurs conforme à un mode de réalisation de l'invention ;
- la figure 10 représente, selon une vue partielle en coupe, le capteur de température de la figure 9 installé dans le guide de connecteurs ;
- la figure 11 représente, selon une vue schématique en trois dimensions, un guide de connecteurs conforme à un autre mode de réalisation de l'invention.

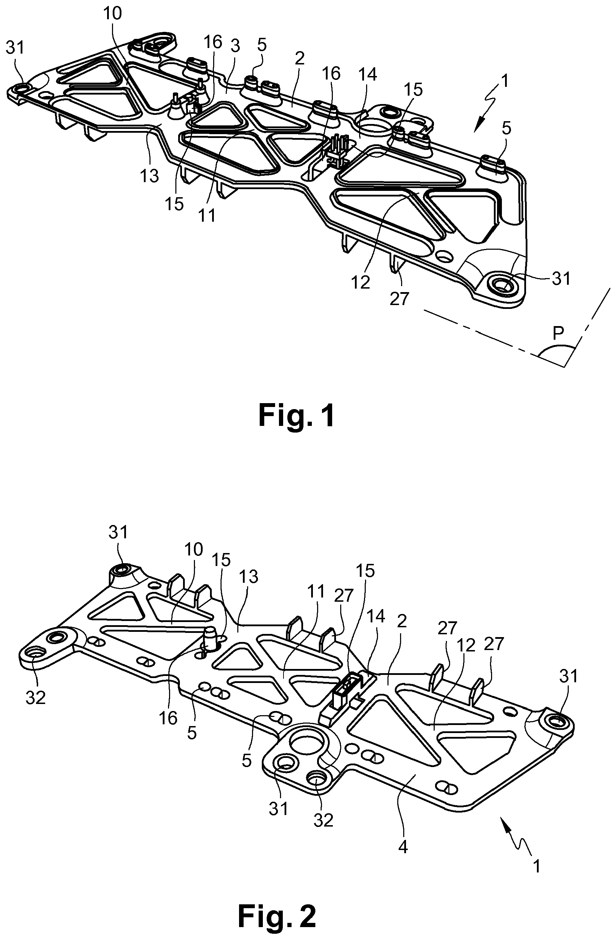

La figure 1 et la figure 2 représentent un guide de connecteurs 1 conforme à un mode de réalisation de l'invention. Le guide de connecteurs 1 est avantageusement formé d'un seul tenant, c'est-à-dire qu'il est avantageusement monobloc. Il peut être formé d'un matériau plastique (y compris composite). Il peut notamment être moulé par injection d'un matériau plastique.

Le guide de connecteurs comporte un corps 2, qui est plat et qui s'étend dans un plan général d'extension P.

Le corps 2 comporte une face supérieure 3 et une face inférieure 4. La face supérieure 3 est destinée à être orientée vers la carte de contrôle de l'onduleur équipée du guide de connecteurs, et la face inférieure 4 est destinée à être orientée vers les modules de puissance de l'onduleur.

Le guide de connecteurs comporte des orifices 5 adaptés au passage de connecteurs mâles, à savoir de broches de connexion.

Par « broche de connexion » ou plus simplement « broche », il est entendu un connecteur mâle sous la forme d'une barrette rigide métallique adaptée à être insérée dans un connecteur femelle correspondant.

Plus particulièrement, chaque orifice 5 est dimensionné pour permettre le passage d'une seule broche de connexion. Les orifices 5 sont répartis et configurés sur le corps 2 du guide de connecteurs 1 de sorte à garantir un positionnement et une orientation précis aux broches qui les traversent.

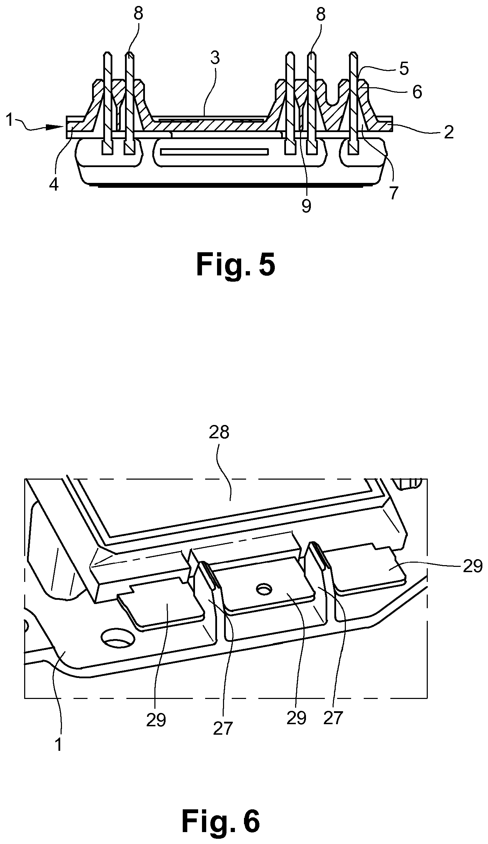

Une configuration des orifices 5 plus particulièrement envisagée est représentée à la figure 5. Selon cette configuration, chaque orifice 5 comporte une partie supérieure 6 qui est cylindrique droite et une partie inférieure 7 qui est évasée.

La partie inférieure 7 évasée permet une légère correction de l'orientation et du positionnement des broches 8 entre elles lors de la mise en place du guide de connecteurs. La partie supérieure 6 assure un bon maintien de la broche 8 en position et en orientation.

Dans le mode de réalisation ici représenté, certains orifices présentent une partie inférieure 7 évasée conique. Néanmoins, certains orifices 5 adjacents sont trop rapprochés entre eux pour pouvoir présenter chacun une partie inférieure conique. En effet, les parties coniques adjacentes de ces orifices se recoupent alors spatialement. Cela augmente le risque qu'une broche 8 soit guidée vers un orifice qu'elle n'est pas censée traverser. Afin de limiter ce risque, une paroi médiane 9 est formée pour séparer les parties évasées de deux orifices 5 adjacents.

Dans l'exemple du mode de réalisation de la figure 1 et de la figure 2, le guide de connecteurs 1 est configuré pour assurer le positionnement relatif et l'orientation relative des broches de commande de trois modules de puissance, et est ainsi destiné à équiper un onduleur comportant trois modules de puissance. Le corps 2 du guide de connecteurs 1 comporte trois portions de recouvrement chacune destinée à recouvrir, en tout ou partie, un module de puissance. Le guide de connecteurs 1 comporte ainsi : une première portion de recouvrement 10, une deuxième portion de recouvrement 11, et une troisième portion de recouvrement 12.

Entre deux portions de recouvrement, le corps du guide de connecteurs comporte une portion intermédiaire pleine. Dans l'exemple représenté, le corps 2 du guide de connecteurs 1 comporte une première portion intermédiaire 13 entre la première portion de recouvrement 10 et la deuxième portion de recouvrement 11 et une deuxième portion intermédiaire 14 entre la deuxième portion de recouvrement 11 et la troisième portion de recouvrement 12. Chaque portion intermédiaire 13, 14, est ainsi réalisée sous la forme d'un bras, et est destinée à être positionnée entre deux modules de puissance (au-dessus desdits modules de puissance).

La portion intermédiaire comporte un logement adapté à recevoir un capteur de température.

Dans l'exemple représenté, pour la complétude de la description, la première portion intermédiaire 13 et la deuxième portion intermédiaire 14 comportent chacune un logement adapté à recevoir un capteur de température. En l'occurrence, le logement 15 de la première portion intermédiaire 13 est adapté à recevoir un premier type de capteur de température tandis que le logement 15 de la deuxième portion intermédiaire 14 est adapté à recevoir un deuxième type de capteur. Bien que cette configuration particulière ne soit pas exclue de l'invention, le guide de connecteurs comporte plus fréquemment un seul capteur de température, ou deux capteurs du même type.

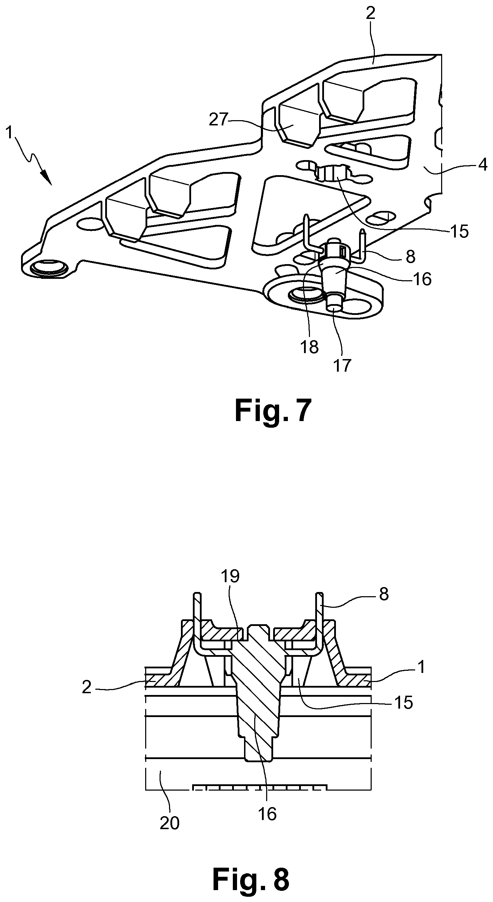

Le capteur de température 16 installé dans le logement 15 de la première portion intermédiaire 13 est représenté plus en détail à la figure 7 et à la figure 8.

Le capteur de température 16 de la figure 7 et de la figure 8 comporte une surface sensible 17 qui doit être mise au contact de la surface dont la température est à mesurer. La surface sensible 17 est en partie basse d'une partie principale 18 du capteur de température 16. Deux broches 8 sortent de la partie principale 18, et sont destinées à délivrer le signal issu du capteur de température 16.

Le capteur de température 16 est introduit dans le logement 15 par le dessous du guide de connecteurs. En d'autres termes, l'ouverture du logement 15 qui permet d'y introduire le capteur de température 16 est située sur la face inférieure 4 du corps 2 du guide de connecteurs 1. Le logement 15 comporte dans ce cas une butée supérieure 19 sur laquelle une face supérieure du capteur de température 16 vient en appui. Un système de clipsage peut également être prévu, empêchant le capteur de température 16 de sortir spontanément du logement 15 lorsque le guide de connecteurs 1 est soulevé et manipulé. Une fois le capteur de température en position d'utilisation, comme représenté à la figure 8, la surface sensible 17 du capteur est au contact d'une plaque de refroidissement 20, qui sert à évacuer de l'énergie thermique des modules de puissance de l'onduleur équipé.

Afin de garantir ce contact, il est possible de prévoir que la distance entre la butée supérieure 19 et la plaque de refroidissement 20 soit légèrement inférieure (par exemple de 0,2 mm) à la distance entre la face supérieure du capteur de température 16 et la surface sensible 17. La butée supérieure 19 peut être configurée pour présenter la souplesse nécessaire pour permettre le montage et assurer une force de pression sur le capteur de température qui garantit son contact sur la plaque de refroidissement 20.

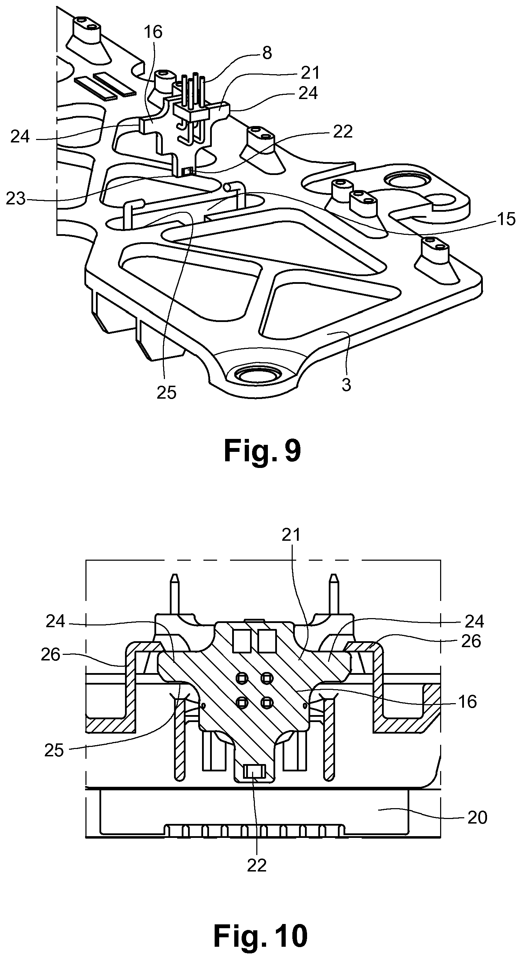

Le capteur de température 16 installé dans le logement 15 de la deuxième portion intermédiaire 14 est représenté plus en détail à la figure 9 et à la figure 10.

Le capteur de température 16 de la figure 9 et de la figure 10 est du type comportant un circuit imprimé 21. Une thermistance 22, par exemple du type « CTN » (pour « coefficient de température négatif ») est installée à une extrémité inférieure 23 du circuit imprimé 21.

Des broches 8 (ici au nombre de quatre) sont liées au circuit imprimé 21, et sont destinées à délivrer le signal issu du capteur de température 16.

Le capteur de température 16 est introduit dans le logement 15 par le dessus du guide de connecteurs. En d'autres termes, l'ouverture du logement 15 qui permet d'y introduire le capteur de température 16 est située sur la face supérieure 3 du corps 2 du guide de connecteurs 1.

Le circuit imprimé 21 comporte deux ailettes 24, qui viennent en appui sur une butée 25 du logement 15. Le logement 15 est ouvert dans sa partie inférieure, c'est-à-dire qu'il comporte une ouverture de son fond, de sorte à pouvoir mettre la thermistance 22 au contact de la surface dont la température doit être mesurée.

Deux griffes 26, mobiles et/ou souples, permettent d'immobiliser le capteur de température 16 dans le logement 15. Tout autre dispositif de retenue, par exemple par clipsage, goupille, etc. peut être mis en œuvre en alternative ou en complément.

Le dispositif de retenue permet de maintenir le capteur 15 au contact de la surface donc la température est mesurée et empêche le capteur de température 16 de sortir spontanément du logement 15 lorsque le guide de connecteurs 1 est manipulé.

Ainsi, une fois le capteur de température 16 en position d'utilisation, comme représenté à la figure 10, la thermistance 22 est au contact d'une plaque de refroidissement 20, qui sert à évacuer de l'énergie thermique des modules de puissance de l'onduleur équipé.

Afin de garantir ce contact, il est possible de prévoir que le dispositif de retenue exerce une force de pression sur le capteur de température 16 qui garantit son contact sur la plaque de refroidissement 20. En alternative ou en complément (dans ce mode de réalisation comme dans tout autre mode de réalisation), un produit assurant une forte conduction thermique, par exemple un mastic thermoconducteur (souvent désigné par l'expression anglophone « gap filler ») ou une interface thermoconductrice (souvent désignée par l'expression anglophone « gap pad ») peut être utilisé pour assurer la conduction thermique entre la plaque de refroidissement et le capteur de température. Comme cela est visible en particulier à la figure 2, le guide de connecteurs 1 peut comporter des murets 27 orthogonaux audit plan général d'extension P du corps du guide de connecteurs 2. La fonction de ces murets 27 est expliquée plus en détail en référence à la figure 6.

La figure 6 représente, selon une vue partielle, un module de puissance 28 installé sous le guide de connecteurs 1 de la figure 1 et de la figure 2. Le module de puissance comporte des bornes 29, ou « connexions extérieures » (également désignées par l'expression anglophone « lead frame ») qui permettent la connexion du module de puissance à une source électrique en courant continu d'une part et à une phase d'une machine électrique d'autre part.

Du fait des tensions élevées dans ces bornes 29, il est important d'assurer une bonne isolation électrique (en particulier entre la borne positive en courant continu et la borne négative en courant continu). Pour garantir cette isolation, et éviter le risque de formation d'arcs électriques, une distance minimale doit être prévue entre les bornes 29. Le risque de formation d'arcs électriques peut également être évité en interposant un matériau isolant entre les bornes. Les murets 27 sont ainsi interposés entre les bornes 29 des modules de puissance, lorsque le guide de connecteurs est assemblé sur les modules de puissance.

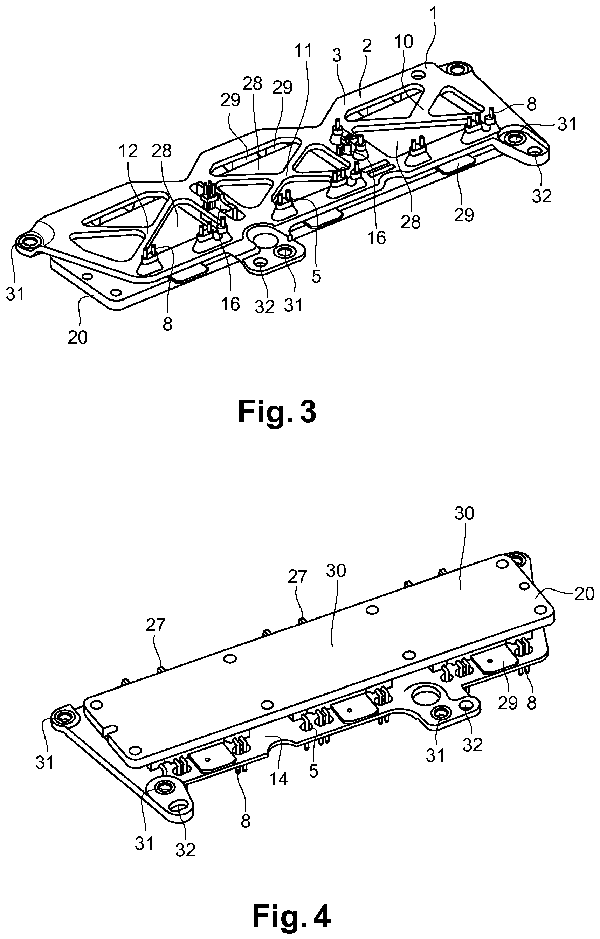

Un système assemblé comportant le guide de connecteurs de la figure 1 et de la figure 2, des modules de puissance 28, et une plaque de refroidissement 20, est représenté à la figure 3 et à la figure 4.

Sur la figure 3, la face supérieure 3 du guide de connecteurs est orientée vers le haut et visible au premier plan. Sur la figure 4, la face inférieure 4 du guide de connecteurs 1 est orienté vers le haut, de sorte que la plaque de refroidissement 20 est visible en partie supérieure du système, au premier plan.

La figure 3 et la figure 4 permettent de visualiser que les modules de puissance 28 sont interposés entre le guide de connecteurs 1 et la plaque de refroidissement 20. La plaque de refroidissement 20 est au contact des modules de puissance et permet une dissipation de l'énergie thermique issue des modules de puissance 28 dans l'air ou dans un liquide de refroidissement, via un système de dissipation 30 pouvant par exemple comporter de nombreuses ailettes.

Les modules de puissance de l'onduleur sont placés côte à côte dans un même plan. Cette disposition est applicable à de nombreux modes de réalisation.

Lors de la mise en appui du guide de connecteurs 1 sur les modules de puissance 28, tandis que lesdits modules de puissance sont au contact (direct ou via une interface thermoconductrice) avec la plaque de refroidissement 20, le (ou les) capteur thermique 16 est amené au contact de la plaque de refroidissement, en s'étendant entre deux modules de puissance 28.

Le guide de connecteurs 1 étant installé sur les modules de puissance 28, un premier module de puissance est recouvert partiellement par la première portion de recouvrement 10 du guide de connecteurs 1. Un deuxième module de puissance est recouvert partiellement par la deuxième portion de recouvrement 11 du guide de connecteurs 1. Un troisième module de puissance est recouvert partiellement par la troisième portion de recouvrement 12 du guide de connecteurs 1.

Les broches de commande de chaque module de puissance 18 traversent le guide de connecteurs 1 par les orifices 5 qu'il comporte, de sorte que leur positionnement et leur orientation relative sont corrigés puis maintenus. Il est alors possible de coiffer le système avec une carte électronique de contrôle (ou une carte électronique unique), en étant certain que les broches de commande vont s'insérer précisément et simultanément dans des connecteurs femelles de la carte électronique. Les connecteurs femelles sont par exemple des trous permettant aux broches 8 de traverser la carte électronique et de les y souder.

Un écran, par exemple en acier ou en aluminium, peut, optionnellement, être interposé entre le guide de connecteurs 1 et la carte électronique, tout en étant maintenu à distance de la carte électronique (par exemple à l'aide d'entretoises isolantes). Comme cela est visible notamment à la figure 3 et à la figure 4, le guide de connecteurs peut également comporter des moyens permettant son indexation en position et sa fixation dans le carter d'un onduleur. L'indexation peut être réalisée à l'aide d'orifices calibrés 32 pour le passage de goupilles ou de doigts d'indexage. Le guide de connecteurs peut en particulier comporter deux orifices calibrés, réalisés avec de faibles tolérances de position et de dimensions.

La fixation peut être prévue par exemple par vis, au travers de trous de fixation 31 dotés, le cas échéant d'inserts par exemple métalliques.

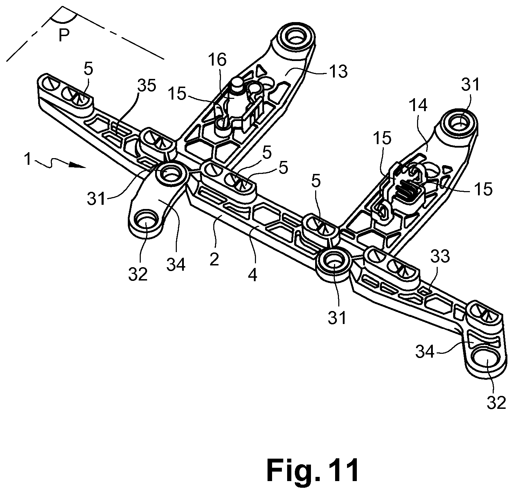

La figure 11 représente, à titre d'exemple, un guide de connecteurs 1 selon un autre mode de réalisation de l'invention. Le guide de connecteurs de la figure 11, bien que présentant une configuration générale très différente, est fonctionnellement similaire au guide de connecteurs des figures 1 à 10. On peut donc généralement se référer à la description des figures 1 à 10 pour le connecteur de la figure 11. Comparativement aux figures 1 à 10, les mêmes signes de référence sont utilisés sur la figure 11, pour désigner les mêmes éléments.

Le guide de connecteurs 1 est représenté à la figure 11 avec sa face inférieure 4 dirigée vers le haut, au premier plan sur la figure 11.

Tout comme le guide de connecteurs précédemment décrit, le guide de connecteurs 1 comporte un corps 2, qui est plat et qui s'étend dans un plan général d'extension P.

Le guide de connecteurs diffère essentiellement de celui des figures 1 à 10 en ce qu'il ne comporte pas de portion de recouvrement des modules de puissance, ou des portions de recouvrement très réduites. Ainsi, le guide de connecteurs étant adapté à un onduleur comportant trois modules de puissance, la première portion intermédiaire 13 et la deuxième portion intermédiaire 14 se présentent sous la forme de bras destinés à être positionnés entre les modules de puissance, au-dessus de ceux-ci, de l'onduleur équipé du guide de connecteurs. Selon la largeur de ces bras formant portion intermédiaire, ils peuvent ou non recouvrir le bord des modules de puissance situés de part et d'autre.

Le guide de connecteurs de la figure 11 se présente ainsi sous la forme générale d'une branche principale 33 sensiblement droite, dans laquelle sont ménagés les orifices 5 pour le passage de connecteurs mâles, à laquelle sont liées deux branches perpendiculaires formant respectivement la portion intermédiaire 13 et la deuxième portion intermédiaire 14. Des extensions 34 sont prévues pour permettre le centrage et l'alignement du guide de connecteurs grâce aux orifices calibrés 32.

Des nervures 35 permettent de rigidifier structurellement le guide de connecteurs. Dans l'exemple de mode de réalisation représenté les nervures 35 forment un motif géométrique propre à rigidifier le guide de connecteurs, comportant par exemple des formes peu ou pas déformables (triangles, hexagones, etc.).

Cette rigidification est importante dans la configuration du guide de connecteurs représentée car il comporte une partie allongée et des trous de fixation 31 centrés. Cette rigidification permet aussi d'éviter de possibles problèmes de vibration lors de la fabrication de l'onduleur. La fabrication du guide de connecteur par injection plastique est également facilitée car les nervures 35 permettent de conserver une épaisseur constante pour l'ensemble du guide de connecteurs.

L'invention ainsi développée permet conjointement de garantir la position et l'orientation des broches de commande des modules de puissance lors de l'assemblage d'un onduleur, et de mettre en position un (ou plusieurs) capteur de température dans l'onduleur.

Cela permet également un montage fiable et sûr d'une carte électronique (typiquement une carte de contrôle) comportant des connecteurs femelles devant recevoir les broches de commande des modules de puissance.

## Revendications

1. Guide de connecteurs pour onduleur, l'onduleur comportant au moins deux modules de puissance (28), à savoir au moins un premier module de puissance et un deuxième module de puissance,
le guide de connecteurs (1) comportant un corps (2) rigide sensiblement plan dans lequel sont ménagés des orifices (5) pour le passage de broches (8) de commande des modules de puissance (28), lesdits orifices (5) étant calibrés et positionnés de sorte à conformer la position et l'orientation desdites broches (8) de commande,
le corps du guide de connecteurs comporte une portion dite intermédiaire (13) qui est destinée à être positionnée entre le premier module de puissance et le deuxième module de puissance,
le guide de connecteurs étant **caractérisé en ce que** ladite portion intermédiaire (13) comporte un logement (15) adapté à recevoir un capteur de température (16).

2. Guide de connecteurs selon la revendication 1, dans lequel les orifices (5) pour le passage des broches comportent une partie supérieure (6) cylindrique droite et une partie inférieure (7) évasée.

3. Guide de connecteurs selon la revendication 2, dans lequel la partie inférieure (7) évasée de tout ou partie des orifices (5) est conique.

4. Guide de connecteurs selon la revendication 2 ou la revendication 3, dans lequel la partie inférieure (7) évasée de deux orifices adjacents comporte une paroi médiane (9) droite.

5. Guide de connecteurs selon l'une des revendications précédentes, dans lequel le logement (15) adapté à recevoir un capteur de température (16) est ouvert sur une face inférieure (4) du corps (2) du guide de connecteurs (1) de sorte à pouvoir insérer le capteur de température (16) dans le logement par ladite face inférieure (4) et le mettre en butée sur une butée supérieure (19) dudit logement (20).

6. Guide de connecteurs selon l'une des revendications 1 à 4, dans lequel le logement (15) adapté à recevoir un capteur de température (16) est ouvert sur une face supérieure (3) du corps (2) du guide de connecteurs (1) de sorte à pouvoir insérer le capteur de température (16) dans le logement (15) par ladite face supérieure (3), le logement (15) comportant en outre une butée (25) permettant la mise en appui du capteur de température (16), ledit logement (16) comportant en outre une ouverture de fond permettant un dépassement du capteur de température (16), le logement (15) étant en outre doté d'un dispositif de retenue du capteur de température.

7. Guide de connecteurs selon l'une des revendications précédentes, dans lequel le corps (2) du guide de connecteurs (1) comporte une première portion de recouvrement (10) destinée à recouvrir au moins partiellement le premier module de puissance, et le corps du guide de connecteurs comporte une deuxième portion de recouvrement (11) destinée à recouvrir au moins partiellement le deuxième module de puissance.

8. Guide de connecteurs selon la revendication 7, comportant trois portions de recouvrement (10,11, 12), pour le recouvrement au moins partiel de trois modules de puissance (28).

9. Guide de connecteurs selon l'une des revendications précédentes, le guide de connecteurs (1) comportant au moins un muret (27) orthogonal à un plan général d'extension (P) du corps (2) du guide de connecteurs (1).

10. Système comportant :
- une pluralité de modules de puissance (28) ; chaque module de puissance (28) comportant des broches (8) de commande,
- un guide de connecteurs (1) conforme à l'une des revendications précédentes, chaque broche (8) de commande des modules de puissance (28) traversant un orifice (5) du guide de connecteurs (1),
- un capteur de température (16) installé dans le logement (15), et
- une plaque de refroidissement (20) au contact des modules de puissance (28),
le capteur de température (16) étant au contact de la plaque de refroidissement (20).

11. Système selon la revendication 10, comportant un guide de connecteurs selon la revendication 9, dans lequel chaque module de puissance (28) comporte des bornes (29) qui s'étendent sensiblement parallèlement au plan général d'extension (P) du corps (2) du guide de connecteurs (1), et dans lequel l'au moins un muret (27) du guide de connecteurs est interposé entres deux bornes (29) adjacentes d'un module de puissance (28).

12. Onduleur comportant un système selon la revendication 10 ou la revendication 11, comportant en outre une carte électronique comportant des connecteurs femelles auxquels sont reliées les broches (8) des modules de puissance (28).

## Patentansprüche

1. Verbindungsführung für Wechselrichter, wobei der Wechselrichter mindestens zwei Leistungsmodule (28), nämlich mindestens ein erstes Leistungsmodul und ein zweites Leistungsmodul, umfasst,
die Verbinderführung (1) einen im Wesentlichen ebenen, steifen Körper (2) aufweist, in dem Öffnungen (5) für den Durchgang von Steuerstiften (8) der Leistungsmodule (28) vorgesehen sind, wobei die Öffnungen (5) so kalibriert und positioniert sind, dass sie die Position und die Ausrichtung der Steuerstifte (8) anpassen,
Der Körper der Steckerführung weist einen so genannten Zwischenabschnitt (13) zur Positionierung zwischen dem ersten Leistungsmodul und dem zweiten Leistungsmodul auf. Die Steckerführung ist **dadurch gekennzeichnet, dass** der Zwischenabschnitt (13) eine Aufnahme (15) aufweist, die zur Aufnahme eines Temperatursensors (16) geeignet ist.

2. Verbinderführung nach Anspruch 1, bei der die Öffnungen (5) für den Durchgang der Stifte einen geraden zylindrischen oberen Abschnitt (6) und einen sich erweiternden unteren Abschnitt (7) aufweisen.

3. Verbinderführung nach Anspruch 2, bei der der sich erweiternde untere Abschnitt (7) der gesamten oder eines Teils der Öffnungen (5) konisch ist.

4. Verbinderführung nach Anspruch 2 oder 3, wobei der sich erweiternde untere Abschnitt (7) zweier benachbarter Öffnungen eine gerade Mittelwand (9) aufweist.

5. Verbinderführung nach einem der vorhergehenden Ansprüche, bei der das Gehäuse (15), das zur Aufnahme eines Temperatursensors (16) geeignet ist, an einer Unterseite (4) des Körpers (2) der Verbinderführung (1) offen ist, sodass der Temperatursensor (16) durch die Unterseite (4) in das Gehäuse eingeführt und an einem oberen Anschlag (19) des Gehäuses (20) anliegt.

6. Steckverbinderführung nach einem der Ansprüche 1 bis 4, bei der das Gehäuse (15), das zur Aufnahme eines Temperatursensors (16) geeignet ist, an einer Oberseite (3) des Körpers (2) der Steckverbinderführung (1) offen ist, sodass der Temperatursensor (16) durch die Oberseite (3) in das Gehäuse (15) eingeführt werden kann, wobei das Gehäuse (15) ferner einen Anschlag (25) aufweist, der das Anlegen des Temperatursensors (16) ermöglicht, wobei das Gehäuse (16) ferner eine Bodenöffnung aufweist, die ein Überragen des Temperatursensors ermöglicht (16), wobei das Gehäuse (15) ferner mit einer Rückhalteeinrichtung für den Temperaturfühler versehen ist.

7. Verbinderführung nach einem der vorhergehenden Ansprüche, bei der der Körper (2) der Verbinderführung (1) einen ersten Abdeckabschnitt (10) zum wenigstens teilweisen Abdecken des ersten Leistungsmoduls und der Körper der Verbinderführung einen zweiten Abdeckabschnitt (11) zum wenigstens teilweisen Abdecken des zweiten Leistungsmoduls aufweist.

8. Steckerführung nach Anspruch 7 mit drei Abdeckabschnitten (10, 11, 12) zur zumindest teilweisen Abdeckung von drei Leistungsmodulen (28).

9. Verbinderführung nach einem der vorhergehenden Ansprüche, wobei die Verbinderführung (1) mindestens eine Wand (27) senkrecht zu einer allgemeinen Erstreckungsebene (P) des Körpers (2) der Verbinderführung (1) aufweist.

10. System mit :
- eine Vielzahl von Leistungsmodulen (28); jedes Leistungsmodul (28) hat Steuerstifte (8),
- eine Steckerführung (1) nach einem der vorhergehenden Ansprüche, wobei jeder Antriebsstift (8) der Leistungsmodule (28) durch eine Öffnung (5) der Steckerführung (1) hindurchgeht,
- einem Temperaturfühler (16), der in dem Gehäuse (15) installiert ist, und
- eine Kühlplatte (20), die die Leistungsmodule (28) berührt,
Der Temperaturfühler (16) ist mit der Kühlplatte (20) in Kontakt.

11. System nach Anspruch 10 mit einer Verbinderführung nach Anspruch 9, wobei jedes Leistungsmodul (28) Anschlüsse (29) aufweist, die sich im Wesentlichen parallel zu der allgemeinen Erstreckungsebene (P) des Körpers (2) der Verbinderführung (1) erstrecken, und wobei die mindestens eine Wand (27) der Verbinderführung zwischen zwei benachbarten Anschlüssen (29) eines Leistungsmoduls (28) angeordnet ist.

12. Wechselrichter mit einem System nach Anspruch 10 oder Anspruch 11, der ferner eine elektronische Karte mit weiblichen Verbindern aufweist, mit denen die Stifte (8) der Leistungsmodule (28) verbunden sind.

## Claims

1. Guide of connectors for inverters, the inverter comprising at least two power modules (28), namely at least a first power module and a second power module,
the connector guide (1) comprising a substantially drawing rigid body (2) in which orifices (5) are provided for the passage of order pins (8) of the power modules (28), said orifices (5) being calibrated and positioned so as to shape the position and orientation of said order pins (8),
the body of the connector guide comprises a so-called intermediate portion (13) which is intended to be positioned between the first power module and the second power module,
the connector guide being **characterized in that** said intermediate portion (13) comprises a housing (15) adapted to a temperature sensor (16).

2. Guide for connectors according to claim 1, in which the orifices (5) for the passage of the pins comprise a straight cylindrical upper part (6) and a flared lower part (7).

3. Connector guide according to claim 2, wherein the flared lower part (7) of all or part of the orifices (5) is conical.

4. Guide for connectors according to claim 2 or claim 3, wherein the flared lower part (7) of two adjacent orifices comprises a straight median wall (9).

5. Connector guide according to one of the previous claims, wherein the housing (15) adapted for a temperature sensor (16) is open on a lower face (4) of the body (2) of the connector guide (1) so as to be able to insert the temperature sensor (16) into the housing via said lower face (4) and to place it in abutment on an upper stop (19) of said housing (20).

6. Connector guide according to any one of claims 1 to 4, wherein the housing (15) adapted for a temperature sensor (16) is open on an upper face (3) of the body (2) of the connector guide (1) so as to be able to insert the temperature sensor (16) into the housing (15) via said upper face (3), the housing (15) further comprising a stop (25) allowing the temperature sensor (16) to be brought into abutment, said housing (16) further comprising a bottom opening allowing the temperature sensor (16) to be exceeded, the housing (15) further being provided with a device for retained the temperature sensor.

7. Connector guide according to one of the previous claims, wherein the body (2) of the connector guide (1) comprises a first overlap portion (10) intended to at least partially cover the first power module, and the body of the connector guide comprises a second overlap portion (11) intended to at least partially cover the second power module.

8. Connector guide according to claim 7, comprising three overlap portions (10, 11, 12), for at least partial overlap of three power modules (28).

9. Connector guide according to one of the previous claims, the connector guide (1) comprising at least one low wall (27) orthogonal to a general drawing of extension (P) of the body (2) of the connector guide (1).

10. System comprising:
- a plurality of power modules (28) ; each power module (28) having order pins (8), connector guide (1) according to one of the previous claims, each order pin (8) of the power modules (28) passing through an orifice (5) of the connector guide (1),
- a temperature sensor (16) installed in the housing (15), and
cooling plate (20) in contact with the power modules (28),
the temperature sensor (16) being in contact with the cooling plate (20).

11. System according to claim 10, comprising a connector guide according to claim 9,
wherein each power unit (28) comprises terminals (29) which extend substantially parallel to the general drawing of extension (P) of the body (2) of the connector guide (1), and wherein the at least one wall (27) of the connector guide is interposed between two adjacent terminals (29) of a power unit (28).

12. Inverter comprising a system according to claim 10 or claim 11, further comprising an electronic board comprising female connectors to which the pins (8) of the power modules (28) are connected.
